# EUROPEAN PATENT APPLICATION

(11) **EP 1 298 229 A1**
(43) Date of publication of application: **02.04.2003**
(21) Application number: 02021725.3
(22) Date of filing: 25.09.2002
(51) Int. Cl.: C23C 14/08

(54) **Method for making an Al2O3 film**

(30) Priority: 26.09.2001 JP 2001295130; 26.09.2001 JP 2001295131; 24.04.2002 JP 2002123191; 10.06.2002 JP 2002167984
(71) Applicant: Tohcello Co., Ltd., Tokyo 104-0031 (JP)
(72) Inventor: Mishina, Noritoshi, Sashima-gun, Ibaraki (JP); Nomoto, Akira, Sashima-gun, Ibaraki (JP); Oka, Takeshi, Sashima-gun, Ibaraki (JP); Toyama, Tatsuya, Sashima-gun, Ibaraki (JP)
(74) Representative: HOFFMANN - EITLE

(57) **Abstract**

An aluminum oxide deposited film of the invention, comprising a substrate film and an aluminum oxide deposit layer of which the peel strength to the substrate film in a wet state is at least 0.3 N/15mm, has an oxygen permeability of not more than 40 ml/m²·day·MPa and a water vapor permeability of not more than 4.0 g/ m²·day. The deposition ratio (A/B) of a fluorescent X-ray intensity (A) kcps (aluminum Kα-ray) of the aluminum oxide deposited film (1) to a fluorescent X-ray intensity (B) kcps (aluminum Kα-ray) of an aluminum deposited film (2) obtained without feeding oxygen is (A/B) ≤ 0.85.

## Description

### FIELD OF THE INVENTION

The present invention relates to aluminum oxide deposited films having excellent transparency and barrier properties to gasses such as oxygen and water vapor and a process for producing the films.

### BACKGROUND OF THE INVENTION

In recent years, transparent gas barrier films formed by depositing inorganic oxide such as silicon oxide or aluminum oxide on a surface of a plastic substrate through vacuum deposition, sputtering, ion plating, chemical vapor deposition or the like have been paid attention as materials having barrier properties to gasses such as oxygen and water vapor.

For producing a gas barrier film having an aluminum oxide deposit layer, a process comprising oxidizing aluminum by feeding an oxygen gas to aluminum that is thermally vaporized by means of electron beam or the like and depositing aluminum oxide on a plastic substrate is usually adopted. However, the thermally vaporized aluminum reacts with oxygen very easily. Therefore, if the quantity of oxygen fed is increased, a dense layer cannot be formed. As a result, a film excellent in gas barrier properties, particularly in water vapor barrier properties, cannot be obtained. On the other hand, if the quantity of oxygen fed is decreased, transparency of the film is lowered. In either case, the quantity of oxygen (oxygen feed rate) and the quantity of aluminum vapor (aluminum vaporization rate) need to be strictly controlled in order to obtain films having stable qualities and excellent gas barrier properties.

As a method to control the deposition quantity of aluminum oxide, a method of maintaining a ratio of an average deposition quantity of aluminum (mol/min) to a feed rate of the oxygen gas (mol/min) in the specific range is known (see Japanese Patent laid-Open Publication No. 103359/1987). In the method described in this publication, the quantity of aluminum adhered on the film and the quantity of aluminum adhered on a masking board or the like that causes a loss vary depending upon the size of an apparatus and the conditions of the deposition, or the reaction state of aluminum varies depending upon the deposition quantity of aluminum. Hence, even if the above ratio is the same, films having the same barrier properties are not necessarily obtained, and there is a fear that an aluminum oxide deposited film stable in qualities such as gas barrier properties cannot be obtained.

A method of controlling the light transmittance during the deposition process is known (see Japanese Patent Laid-Open Publication No. 81219/2001). The light transmittance, however, is determined by two factors of an oxidized state of aluminum of the deposit layer and a thickness of the deposit layer, and hence there is a fear that an aluminum oxide deposited film stable in qualities such as gas barrier properties cannot be obtained only by controlling the light transmittance.

Further, a method of controlling x of the AlOₓ deposit layer is known (see Japanese Patent Laid-Open Publication No. 170427/1999). However, it is difficult to measure the quantity of oxygen during the deposition in the deposition apparatus. If the deposit layer is temporarily exposed to the atmosphere to measure the oxygen quantity, the deposit layer reacts with oxygen of the atmosphere to change the x value, and hence there is a fear that an aluminum oxide deposited film stable in qualities such as gas barrier properties cannot be obtained, similarly to the above methods.

### OBJECT OF THE INVENTION

The present inventors have earnestly studied to develop a process for producing an aluminum oxide deposited film, by which an aluminum oxide deposited film stable in qualities such as gas barrier properties and having an aluminum oxide deposit layer excellent in water resistance can be readily obtained even if the production conditions such as processing rate are changed. As a result, the present inventors have found that an aluminum oxide deposited film stable in qualities such as gas barrier properties and having an aluminum oxide deposit layer excellent in water resistance can be obtained by setting the ratio of a fluorescent X-ray intensity (A) kcps of the resulting aluminum oxide deposited film (1) to a fluorescent X-ray intensity (B) kcps of an aluminum deposited film (2) obtained without feeding oxygen, within the specific range. Based on the finding, the present invention has been accomplished.

It is another object to provide a deposited film having the above properties and excellent in laminate strength after boiling of a laminated film obtained by laminating a heat-sealing film on aluminum oxide deposited film.

### SUMMARY OF THE INVENTION

The present invention resides in an aluminum oxide deposited film comprising a substrate film and an aluminum oxide deposit layer of which the peel strength to the substrate film in a wet state is at least 0.3 N/15mm.

In the present invention, in addition to the above properties, the aluminum oxide deposited film preferably has an oxygen permeability of not more than 40 ml/m²·day·MPa and a water vapor permeability of not more than 4.0 g/m²·day.

With respect to the aluminum oxide deposited film of the invention, the ratio (A/B) of a fluorescent X-ray intensity (A) kcps (aluminum Kα-ray) of the aluminum oxide deposited film (1) to a fluorescent X-ray intensity (B) kcps (aluminum Kα-ray) of an aluminum deposited film (2) obtained without feeding oxygen is preferably (A/B) ≤ 0.85.

The present invention preferably resides in an aluminum oxide deposited film comprising a substrate film and aluminum oxide deposit layer, obtained by depositing aluminum oxide on one surface of the substrate film in such a manner that the ratio (A/B) is 0.35 ≤ (A/B) ≤ 0.85, and also resides in a process for producing the film.

The aluminum oxide deposited film of the invention can be obtained by a process comprising depositing aluminum oxide on one surface of a substrate film in such a manner that the ratio (A/B) is a number satisfying the condition of 0.35 ≤ (A/B) ≤ 0.65 and then oxidizing the aluminum oxide deposit layer.

With respect to the aluminum oxide deposited film, the fluorescent X-ray intensity (A) kcps of the aluminum oxide deposited film (1) is preferably in the range of 0.5 to 10 kcps.

### DETAILED DESCRIPTION OF THE INVENTION

The aluminum oxide deposited film of the invention and the process for producing the film are described in detail hereinafter.

The substrate film used for the aluminum oxide deposited film of the invention is usually a sheet or film substrate comprising a thermoplastic resin. As the thermoplastic resin, various thermoplastic resins hitherto known are employable. Examples of the resins include polyolefins, such as polyethylene, polypropylene, poly-4-methyl-1-pentene and polybutene; polyesters, such as polyethylene terephthalate, polybutylene terephthalate and polyethylene naphthalate; polyamides, such as nylon-6, nylon-66 and polymetaxylene adipamide; polyvinyl chloride; polystyrene; ionomers; and mixtures thereof. Of these, thermoplastic resins having excellent stretchability and transparency, such as polypropylene, polyethylene terephthalate and polyamide, are preferable. The substrate film made of such a thermoplastic resin may be an unstretched film or a stretched film.

When the stretched film is used in the invention, a biaxially oriented film is preferably employable.

It is preferable to subject the deposited surface of the substrate film to a surface treatment such as corona discharge treatment, flame treatment, plasma treatment or primer coating treatment to enhance adhesion to aluminum oxide.

The substrate film may be a single-layer film using one kind of a resin, or a multi-layer film.

When a biaxially oriented film having been precoated with a polyurethane resin on its one surface (laminate surface) is used as the multi-layer film, a deposited film obtained by laminating a heat-sealing film on the polyurethane-precoated surface of a film wherein aluminum oxide is deposited on the biaxially oriented film has excellent laminate strength after boiling.

As the polyurethane resin, a resin generally used for an adhesive for films, such as a dry laminating adhesive, an aqueous laminating adhesive, a solventless laminating adhesive or an electron ray-curing laminating adhesive, is employable. Examples of such polyurethane resins include polyester type polyurethane resins, polyether type polyurethane resins and polyurethane-polyurea resins. Although the polyurethane resin may be an aqueous dispersion type resin or a solvent type resin, preferable is an aqueous dispersion type polyurethane resin from the viewpoints of ease of adjusting the crosslinking degree of the polyurethane resin layer and environmental problem of the production field. The aqueous dispersion type polyurethane resin is preferably a self-emulsifiable polyurethane resin wherein a hydrophilic group such as carboxylate group (e.g., -COONa) or sulfonate group (e.g., -SO₃Na) is introduced into the main chain or the side chain of the polyurethane resin. In case of the solvent type resin, a three-dimensional structure is formed by the use of an isocyanate resin as a crosslinking agent. On the other hand, in many cases of the aqueous dispersion type resin, a linear polyurethane structure is formed or a polyurethane-polyurea resin is produced. Therefore, a crosslinking agent such as melamine resin, epoxy resin or imine resin may be added in an amount of about 3 to 10 % by weight based on the polyurethane resin, or an acid catalyst can be added in an amount of about 0.5 to 1 % by weight based on the polyurethane resin to accelerate the curing reaction. Such a crosslinking agent not only improves water resistance and solvent resistance of an easy-adhesive film but also contributes to enhancement of adhesion properties.

The aqueous dispersion type resin sometimes contains an anti-foaming agent or a surface active agent such as an emulsifying agent, and the anti-foaming agent or the surface active agent may cause a problem in the later stage. Therefore, it is preferable to use a resin containing none of those agents. If the anti-foaming agent is present, poor appearance attributable to the anti-foaming agent may take place. If the surface active agent is present, poor appearance such as whitening of the biaxially oriented film or gas barrier property defect after deposition may take place.

In the substrate film for use in the invention, inorganic fine particles or organic fine particles may be contained. By the addition of such particles, blocking of the substrate film can be prevented.

The biaxially oriented substrate film whose laminate surface has been precoated with a polyurethane resin (sometimes referred to as a "biaxially oriented precoated substrate film" simply hereinafter), which can be preferably used in the invention, is a biaxially oriented film obtained by the precoating orienting method comprising coating the aforesaid thermoplastic resin film with the polyurethane resin before film orientation, orienting the thermoplastic resin film coated with the polyurethane resin and then thermosetting. This biaxially oriented film is different from a film obtained by biaxially orienting the thermoplastic resin film and then coating the film with a polyurethane resin.

In case of a successively biaxially oriented film, coating with the polyurethane resin may be carried out before stretching of the extrusion sheet in the machine direction, or a film having been stretched in the machine direction may be coated with the polyurethane resin, followed by stretching in the cross direction. For coating the film with the polyurethane resin, various methods such as air knife coating and bar coating are available.

An example of the process for producing the biaxially oriented precoated substrate film is a process comprising feeding pellets, particles or chips of a thermoplastic resin such as polyethylene terephthalate, polypropylene or polyamide to an extruder, heat melting them, extruding the molten resin into a sheet from the T-die, if necessary forming a film by electrostatic casting or the like with bringing the sheet into contact with a cooling drum to quench the sheet, then coating the resulting unstretched sheet or the film stretched in the machine direction with the polyurethane resin and stretching the film by successive biaxial orientation, simultaneous biaxial orientation or stretching in the cross direction. The stretching conditions for producing the biaxially oriented film, such as stretching temperature and stretch ratio, can be determined suitably for the thermoplastic resin used. In case of, for example, polyethylene terephthalate, it is desirable that the temperature is set to 90 to 145°C, stretching is carried out in a stretch ratio of 3.0 to 5.0 times in each of the machine and the cross directions, and then thermosetting is conducted at 210 to 240°C. According to this process, plural heating stages such as preheating stage, stretching stage and thermosetting stage are present, and in these heating stages, the film is independently heated, whereby the adhesion of the polyurethane resin layer to the substrate film in the biaxially oriented film is enhanced.

From the viewpoints of adhesion of the polyurethane resin layer to the later-described heat-sealing layer (heat- sealing film) and film productivity, the thickness of the polyurethane resin layer is preferably in the range of 0.01 to 0.5 g/m², still preferably 0.03 to 0.1 g/m². If the thickness of the polyurethane resin layer is smaller than 0.01 g/m², the adhesion is liable to be insufficient, and if the thickness is larger than 0.5 g/m², blocking of the film tends to occur.

The biaxially oriented precoated substrate film preferably used in the invention is a biaxially oriented precoated substrate film whose laminate surface has been precoated with a polyurethane resin. On the other surface (non-laminate surface) not having been precoated with polyurethane resin, aluminum oxide is deposited. Even if aluminum oxide is deposited on the surface (laminate surface) of the substrate film where the polyurethane resin layer has been laminated, oxygen barrier properties are not improved so much as compared with a film wherein aluminum oxide is deposited on the non-laminate surface. In the present invention, therefore, aluminum oxide is deposited on the non-laminate surface of the biaxially oriented precoated substrate film. It is preferable to subject the non-laminate surface of the biaxially oriented precoated substrate film to a surface treatment such as corona discharge treatment, flame treatment, plasma treatment or primer coating treatment to enhance adhesion to aluminum oxide.

In the present invention, the thickness of the substrate film is in the range of usually 5 to 50 µm, preferably 9 to 30 µm.

The aluminum oxide deposited film (A) of the invention is an aluminum oxide deposited film (A-1) having a specific peel strength, and is an aluminum oxide deposited film (A-2) having a specific oxygen permeability and the like. In the aluminum oxide deposited film (A-1), the peel strength of the aluminum oxide deposit layer to the substrate film in a wet state is in the range of 0.3 to 15 N/15 mm, preferably 0.5 to 10 N/15 mm, particularly preferably 1 to 10 N/15 mm.

The aluminum oxide deposited film (A-2) of the invention has gas barrier properties of an oxygen permeability of not more than 40 ml/m²·day·MPa, preferably not more than 30 ml/m²·day·MPa, and a water vapor permeability of not more than 4.0 g/m²·day, preferably not more than 3.0 g/m²·day.

In the measurement of the peel strength of the aluminum oxide deposit layer to the substrate film with respect to the aluminum oxide deposited film of the invention, it is infeasible to conduct a peel test of the aluminum oxide deposit layer itself because this layer is extremely thin. In order to measure the peel strength of the aluminum oxide deposit layer to the substrate film in the invention, therefore, it is necessary that the aluminum oxide deposit layer is coated with an adhesive, then another film is laminated thereon and the film thus laminated is peeled from the substrate film to measure the peel strength of the aluminum oxide deposit layer to the substrate film. In this method, however, the peel strength of the aluminum oxide deposit layer to the substrate film is inevitably influenced by the adhesive used for the laminating and the type of another film.

In the present invention, accordingly, the peel strength of the aluminum oxide deposit layer to the substrate film in a wet state is measured in the following manner. The surface of the aluminum oxide deposit layer is coated with a polyurethane dry laminating adhesive (available from Mitsui Takeda Chemicals Ltd., Takelac A310:Takenate A3 = 12:1 (mixing weight ratio), coating weight: 3 g/m²), then thereon is laminated a liner low-density polyethylene film (available from Tohcello, Co., Ltd., TUX FCS) having a thickness of 50 µm and a density of 0.920 g/cm³ or biaxially oriented polypropylene film (OPP film, available from Tohcello, Co., Ltd., trade name: ME-1)), and the substrate film is backed up with an adhesive tape of a biaxially oriented polypropylene film having a thickness of 50 µm to prepare a laminated film. The laminated film is cut to give a test specimen of 15 mm width, and the substrate film and the linear low-density polyethylene film (or the OPP film) are partially separated from each other at the interface between them. After or with dropping water on the separate surface, a 180°-peel strength is measured at a peel rate of 300 mm/min, and the thus measured peel strength is regarded as a peel strength in a wet state in the present invention.

Whether the aluminum oxide deposit layer is peeled off from the substrate film or not can be confirmed by subjecting the surface of the substrate film to fluorescent X-ray measurement after the peel test. That is to say, if aluminum oxide is not detected on the surface of the substrate film, interfacial separation between the aluminum oxide deposit layer and the substrate film has occurred, and the peel strength measured at this time is a peel strength of the aluminum oxide deposit layer to the substrate film. On the other hand, if all the aluminum oxide remains on the substrate film, the peel strength measured at this time is a peel strength of the aluminum oxide deposit layer to the adhesive layer, and this means that the measurement of the peel strength of the aluminum oxide deposit layer to the substrate film has not been made. A part of the aluminum oxide remaining on the substrate film means that the aluminum oxide deposit layer is broken when peeled, and this means that the peel strength of the aluminum oxide deposit layer to the substrate film is higher than the breaking strength (measured value) of the aluminum oxide deposit layer.

With respect to the aluminum oxide deposited film having the above specific peel strength of the invention, the ratio (A/B) (sometimes referred to as "deposition ratio" hereinafter) of a fluorescent X-ray intensity (A) kcps of the aluminum oxide deposited film (1) to a fluorescent X-ray intensity (B) kcps of an aluminum deposited film (2) obtained without feeding oxygen is preferably (A/B) ≤ 0.85. If the deposition ratio is larger than 0.85, there is a fear that bond strength (peel strength) in a wet state is not improved. In the present invention, the deposition ratio is still preferably 0.35 ≤ (A/B) ≤ 0.85, and particularly preferably 0.45 ≤ (A/B) ≤ 0.80. If the deposition ratio is 0.45 ≤ (A/B) ≤ 0.80, the deposited film having both low oxygen permeability and low water vapor permeability, i.e. excellent resistance to oxygen permeation and water vapor permeation (gas barrier properties), in addition to the above specific peel strength, is obtained. If the deposition ratio is less than the lower limit of the above range, the resulting film does not have excellent gas barrier properties. If the deposition ratio is larger than the upper limit of the above range, the resulting film has poor transparency.

In the present invention, the fluorescent X-ray intensity (A) kcps of the aluminum oxide deposited film (1) is measured in the following manner. To a deposition apparatus, a given quantity of oxygen is fed and the quantity of aluminum vaporized is controlled so that the light transmittance in the processing becomes a prescribed value, to obtain an aluminum oxide deposited film, or a given quantity of oxygen is fed under the conditions which are controlled so that a prescribed quantity of aluminum can be deposited, to obtain an aluminum oxide deposited film. Then, the aluminum Kα-ray intensity of the test specimen obtained from the aluminum oxide deposited film is measured by the use of a fluorescent X-ray analytical instrument ZSX100s (manufactured by Rigaku Industrial Co.), and the thus measured fluorescent X-ray intensity is taken as (A) kcps.

The fluorescent X-ray intensity (B) kcps of the aluminum deposited film (2) obtained without feeding oxygen is measured in the following manner. Deposition of aluminum is carried out in the same manner as described in the above production of the aluminum oxide deposited film, except that oxygen is not fed, to obtain an aluminum deposited film. Then, the aluminum Kα-ray intensity of the test specimen obtained from the aluminum deposited film is measured by the use of a fluorescent X-ray analytical instrument ZSX100s (manufactured by Rigaku Industrial Co.), and the thus measured fluorescent X-ray intensity is taken as (B) kcps.

From the obtained fluorescent X-ray intensity (A) kcps and fluorescent X-ray intensity (B) kcps, the deposition ratio (A/B) is calculated.

In the present invention, the fluorescent X-ray intensity (A) kcps of the aluminum oxide deposited film (1) is in the range of preferably 0.5 to 10 kcps, more preferably 0.5 to 8 kcps, still more preferably 0.5 to 5 kcps. When the fluorescent X-ray intensity (A) kcps of the aluminum oxide deposited film (1) is in the above range, an aluminum oxide deposited film having excellent transparency and gas barrier properties can be obtained.

Although the thickness of the aluminum oxide deposit layer is not specifically restricted, it is in the range of usually 15 to 500 Å, preferably 20 to 450 Å. If the thickness is less than 15 Å, there is a fear that a film having excellent gas barrier properties is not obtained. If the thickness exceeds 500 Å, the resulting film is liable to have poor flexibility.

In order to impart heat-sealing properties to the aluminum oxide deposited film of the invention, a heat-sealing layer maybe laminated on the substrate film surface and/or the aluminum oxide deposit layer surface.

One of processes for producing the aluminum oxide deposited film of the invention is a process comprising depositing aluminum oxide on one surface of the substrate film by allowing oxygen to react with aluminum vapor in vacuo (under reduced pressure) in such a manner that the ratio (A/B) (deposition ratio) of a fluorescent X-ray intensity (A) kcps of the aluminum oxide deposited film (1) to a fluorescent X-ray intensity (B) kcps of an aluminum deposited film (2) obtained without feeding oxygen is 0.35 ≤ (A/B) ≤ 0.85, preferably 0.45 ≤ (A/B) ≤ 0.80. The fluorescent X-ray intensity (A) of the resulting aluminum oxide deposited film (1) depends upon the feed rate of oxygen. When the feed rate of oxygen (degree of oxidation) is increased, the deposition quantity of aluminum is decreased, and hence the fluorescent X-ray intensity (A) becomes small. When the feed rate of oxygen (degree of oxidation) is decreased, the deposition quantity of aluminum is increased, and hence the fluorescent X-ray intensity (A) becomes large. The deposition quantity of aluminum obtained when oxygen is not fed at all is indicated by the fluorescent X-ray intensity (B).

The deposition quantity of aluminum oxide (metallic aluminum) depends upon the processing rate (treating rate) of the substrate film, deposition efficiency of the vaporized aluminum on the substrate film, vaporization rate of aluminum, etc.

There is a correlation between the deposition quantity of aluminum oxide (aluminum) and the light transmittance of the deposited film. If the oxidized state is the same, the light transmittance of the deposited film in the processing is lowered as the deposition quantity of aluminum oxide is increased.

By installing a fluorescent X-ray measuring equipment in the apparatus for producing the aluminum oxide deposited film of the invention, the deposition quantity of aluminum oxide in the aluminum oxide deposited film obtained can be directly measured, and on the basis of the measured value, the deposition conditions can be directly controlled.

However, even when the fluorescent X-ray measuring equipment is not installed in the apparatus, it is preferable that deposited films different in heating rate, vaporization rate of metallic aluminum, feed rate of oxygen, etc. are previously produced in the deposition apparatus used, then the fluorescent X-ray intensity (A) and the fluorescent X-ray intensity (B) of the deposited films are measured, and a calibration curve showing a relation between the conditions, such as processing rate, vaporization rate of metallic aluminum, feed rate of oxygen and light transmittance, and the measured values of the fluorescent X-ray intensity (A) and fluorescent X-ray intensity (B) is determined.

By the control of, for example, a feed rate of oxygen and a quantity of the aluminum vapor, the deposition ratio (A/B) can be set within the range defined above. The feed rate of oxygen can be set to a prescribed value by the use of a mass flow controller. The feed rate of oxygen greatly varies depending upon the processing rate, the film thickness, etc., and, for example, under the conditions of a deposition rate of 600 m/min and a light transmittance of 83 %, the feed rate of oxygen has only to be set in the range of preferably 0.9 to 4.6 liters/min, more preferably 1.9 to 4.2 liters/min, based on 1 m of a width of the substrate film. The quantity of aluminum vapor can be controlled on the basis of the light transmittance with a light having a wavelength of 350 nm or the light transmittance of an aluminum oxide deposit layer given when the feed rate of oxygen is set to a constant value.

By installing a light transmittance measuring equipment (light transmittance meter) into the deposition apparatus, the light transmittance of the film deposited aluminum oxide can be always observed during the deposition process. In this case, by setting the light transmittance of the aluminum oxide deposited film within the range of preferably 70 to 95 %, still preferably 75 to 90 %, the deposition ratio (A/B) can be determined within the prescribed range of the invention.

The device (feed nozzle) to feed oxygen for oxidizing aluminum is preferably equipped on the unwind side of the substrate film, between the substrate film and a masking board, in the width direction of the substrate film and in the zone where the masking board is set, and this device is preferably arranged in such a manner that oxygen can be fed in the rotation direction of a chill roll and against the aluminum vapor. When the device is equipped at such a position, oxygen is not fed to aluminum that is adhered on the masking board but can be fed to only aluminum that is deposited on the substrate film, and as a result, lowering of degree of vacuum (degree of reduced pressure) caused by feed of excess oxygen can be prevented. It is preferable that the thus fed oxygen is brought into contact with aluminum vapor to perform reaction and the resulting aluminum oxide is deposited on the substrate film. If feeding of oxygen is carried out from not the substrate film unwind side but the substrate film wind-up side, there is a fear that the peel strength in a wet state is not improved.

In the reaction of oxygen with aluminum vapor in vacuo (under reduced pressure) to form an aluminum deposit layer on the substrate film in the present invention, oxygen is fed from the oxygen feed nozzle that is arranged on the unwind side of the substrate film and is positioned at a distance of usually 1 to 150 mm, preferably 1 to 120 mm, from the substrate film. If the distance between the oxygen feed nozzle and the substrate film is less than 1 mm, it becomes difficult to secure the position of the oxygen feed nozzle in the designing. If the distance between the oxygen feed nozzle and the substrate film exceeds 150 mm, there is a fear that the peel strength in a wet state is not improved.

For heating aluminum, various methods, such as electron beam method (EB method), radiofrequency induction heating method and resistance heating method, can be adopted. In the present invention, vacuum deposition by the electron beam method is preferable because thermal efficiency is good, high-speed deposition is feasible, and uniform distribution of film thickness is easily obtainable.

The deposition rate is preferably as high as possible within the range permitted by the apparatus. From the viewpoint of production, it is in the range of preferably 10 to 1000 m/min, particularly preferably 50 to 1000 m/min. When the deposition rate is in this range, the aluminum oxide deposited film of the invention can be stably produced.

The aluminum oxide deposited film of the invention is obtained by depositing aluminum oxide on one surface of the substrate film in such a manner that the deposition ratio (A/B) is in the specific range, as described above. In the present invention, further, the aluminum oxide deposited film can also be produced by depositing aluminum oxide on the substrate film in such a manner that the deposition ratio (A/B) is in the specific range and then bringing the aluminum oxide deposit layer into contact with oxygen as described below.

That is to say, another process for producing an aluminum oxide deposited film according to the invention is a process comprising allowing oxygen to react with aluminum vapor in vacuo (under reduced pressure) to deposit aluminum oxide on the substrate film in such a manner that the ratio (A/B) of a fluorescent X-ray intensity (A) kcps of the aluminum oxide deposited film (1) to a fluorescent X-ray intensity (B) kcps of an aluminum deposited film (2) obtained without feeding oxygen is 0.35 ≤ (A/B) ≤ 0.65, preferably 0.4 ≤ (A/B) ≤ 0.65, and then bringing the aluminum oxide deposit layer into contact with oxygen to further oxidize the aluminum oxide deposit layer and thereby produce an aluminum oxide deposited film.

An example of a method to oxidize the aluminum oxide deposit layer is a method of rewinding the film in the atmosphere after completion of the deposition. By rewinding the aluminum oxide deposited film in the atmosphere, oxygen is introduced into a roll of the deposited film wound up to further oxidize the aluminum oxide, whereby stable gas barrier properties can be exhibited even in the region of low deposition ratio. The period of time before the rewinding is preferably short, and the rewinding is desirably carried out as soon as possible after completion of the deposition though it depends upon the degree of tightness of the roll of the film wound up, etc. The rewinding is carried out within preferably 5 days, more preferably 3 days, most preferably 2 days, after completion of the deposition. When the rewinding is carried out within this period, oxidation can be promoted without deterioration of gas barrier properties or water vapor barrier properties. In order to sufficiently oxidize the aluminum oxide with oxygen introduced by the rewinding, it is preferable to allow the film to stand for one day or more after the rewinding.

Another example of the method to oxidize the aluminum oxide deposit layer is a method of bringing the aluminum oxide deposit layer into contact with oxygen and oxygen plasma in the deposition apparatus before winding-up of the aluminum oxide deposited film, preferably a method of bringing the aluminum oxide deposit layer into contact with oxygen and oxygen plasma in one or plural plasma discharge chambers equipped in the deposition apparatus. By bringing the aluminum oxide deposit layer into contact with oxygen and oxygen plasma in the plasma discharge chamber equipped in the deposition apparatus, oxygen and oxygen plasma are less diffused as compared with the case where a plasma discharge chamber is not equipped in the apparatus, whereby oxygen and oxygen plasma can be introduced to the aluminum oxide deposit layer in higher gas concentrations. Moreover, the degree of reduced pressure in the deposition apparatus is hardly lowered even by the feeding of oxygen and oxygen plasma. The feed rate of oxygen is in the range of preferably 0.1 to 3 liters/min, more preferably 0.1 to 2 liters/min, based on 1 m of a width of the aluminum oxide deposited film. The plasma discharge chamber may be equipped at one or plural positions. If the number of the chambers is larger, oxidation is more easily promoted and can be more stably promoted.

In the present invention, after deposition of aluminum oxide, the aluminum oxide deposit layer is brought into contact with oxygen to perform post-oxidation, so that the feed rate of oxygen during the deposition of aluminum oxide is slightly different from that in the aforesaid process. The feed rate of oxygen greatly varies depending upon the processing rate, the aluminum oxide thickness, etc., and, for example, under the conditions of a deposition rate of 600 m/min and a light transmittance of 83 %, the feed rate of oxygen has only to be in the range of preferably 3.4 to 6.5 liters/min, more preferably 3.4 to 6.1 liters/min, based on 1 m of a width of the aluminum oxide deposited film. The quantity of aluminum vapor can be controlled on the basis of the light transmittance with a light having a wavelength of 350 nm or the light transmittance of an aluminum oxide deposit layer given when the feed rate of oxygen is set to a constant value.

In the above case, by setting the light transmittance of the aluminum oxide deposited film within the range of preferably 70 to 98 %, more preferably 75 to 96 %, the deposition ratio (A/B) can be determined within the prescribed range of the invention.

In the above process that the deposited film is brought into contact with oxygen after the aluminum oxide deposited film is formed as described above, details of arrangement of a device to feed oxygen for oxidizing aluminum, method of heating aluminum, deposition rate, destaticization of the substrate film, surface treatment of the substrate film, etc. are the same as those described above.

In the process for producing the aluminum oxide deposited film according to the invention, after oxygen is fed from the unwind side of the substrate film to deposit aluminum oxide on one surface of the substrate film, the resulting aluminum oxide deposit layer can be brought into contact with oxygen in the same manner as described above in detail to further oxidize the aluminum oxide.

The advantages of the present invention are as follows. The aluminum oxide deposited film of the invention is stable in barrier properties, such as oxygen gas barrier properties and water vapor barrier properties, as compared with a conventional aluminum oxide deposited film. Further, the aluminum oxide deposited film is excellent in water resistance (bond strength between the aluminum oxide deposit layer and the substrate film) , especially water resistance in a wet state.

If a biaxially oriented film having been precoated with a polyurethane resin is used as a substrate film and aluminum oxide is deposited on the non-laminate surface (surface not having been precoated with polyurethane resin) of the substrate film, a deposited film excellent in oxygen gas barrier properties, water vapor barrier properties, water resistance (especially in a wet state) , etc. can be obtained. Further, if a heat-sealing film is laminated on the polyurethane-precoated surface of the biaxially oriented film, a film excellent in laminate strength can be obtained.

According to the present invention, the deposition state of aluminum oxide is controlled utilizing the deposition ratio (A/B) that is a fluorescent X-ray intensity ratio, and thereby an aluminum oxide deposited film stable in qualities such as gas barrier properties and having an aluminum oxide deposit layer excellent in water resistance can be obtained, as described above. That is to say, the aluminum oxide deposited film of the invention having excellent oxygen gas barrier properties and water vapor barrier properties, and having an aluminum oxide deposit layer excellent in water resistance, can be stably obtained by a process comprising allowing oxygen to react with aluminum vapor in vacuo (under reduced pressure) to form an aluminum oxide deposit layer on a substrate film in such a manner that the deposition ratio (A/B) is in a specific range and then, when needed, bringing the aluminum oxide deposit layer into contact with oxygen to promote oxidation. By controlling the properties of the aluminum oxide deposited film on the basis of the deposition ratio, deposition conditions suitable for various deposition rates can be found. According to the invention, further, an aluminum oxide deposited film having stable oxygen gas barrier properties, excellent water vapor barrier properties and transparency can be obtained even if the deposition ratio is relatively low.

Furthermore, by allowing oxygen fed from the unwind side of the substrate film to react with aluminum vapor to deposit aluminum oxide on one surface of the substrate film, an aluminum oxide deposited film exhibiting high bond strength between the substrate film and the aluminum oxide deposit layer even in a wet state can be obtained.

The aluminum oxide deposited film of the invention is employable for various applications of packaging, particularly packaging of liquids or moist foods and packaging of foods to be heated, such as foods to be boiled or retort pouch foods. Even if the aluminum oxide deposited film is used for packaging of foods to be heated, such as foods to be boiled or retort pouch foods, it can be favorably used without occurrence of separation from the laminate film when heated. Further, if a biaxially oriented film precoated with polyurethane resin is used as a substrate film, an aluminum oxide deposited film has excellent laminate strength (bond strength) so that the deposited film is favorably used for the above-mentioned applications.

Moreover, the deposited film of the invention can be favorably used not only as packaging material for foods but also as packaging material employable in various fields such as fields of medicaments, cosmetics and industrial materials.

### EXAMPLES

The present invention is further described with reference to the following examples, but it should be construed that the invention is in no way limited to those examples.

The properties in the examples and the comparative examples were measured by the following methods.

### (1) Measurement of oxygen permeability

The oxygen permeability of a film was measured under the conditions of a temperature of 20°C and a humidity of 90 %RH by the use of an oxygen permeability measuring machine (manufactured by MOCON Co., OXTRAN2/20).

### (2) Measurement of water vapor permeability

Using a film, a bag was prepared, then calcium chloride was placed therein, and the top of the bag was heat-sealed so as to have a surface area of 0.01 m². The bag was allowed to stand for 3 days under the conditions of a temperature of 40°C and a humidity of 90 %RH, and the change in weight was measured. On the basis of the change in weight, the water vapor permeability was evaluated.

### (3) Fluorescent X-ray intensity

The Kα-ray of aluminum was measured by the use of a fluorescent X-ray analytical instrument (manufactured by Rigaku Industrial Co., ZSX100s).

### (4) Light transmittance and control of aluminum deposition quantity

The light transmittance at 350 nm (light transmittance of PET: 100%) was measured in the deposition apparatus, and in order to control the aluminum deposition quantity, the output of the electron beam was controlled in such a manner that the light transmittance became a prescribed value.

### (5) Measurement of residual percentage

The fluorescent X-ray intensity (A) kcps (aluminum Kα-ray) of the aluminum oxide deposited film was beforehand measured. Then, using the aluminum oxide deposited film obtained after the measurement of peel strength, a fluorescent X-ray intensity (C) kcps (aluminum Kα-ray) of the aluminum oxide remaining on the substrate film surface was measured. A value of (C)/(A)×100 is taken as a residual percentage.

### (6) Measurement of peel strength in wet state

A laminated film was cut to give a test specimen of 15 mm width, and the substrate film and the LLDPE film or the OPP film bonded to the deposit layer were partially separated from each other at the interface between them. After water was dropped on the separate surface, the 180°-peel strength of the thus treated specimen was measured at a peel rate of 300 mm/min, and was regarded as a peel strength.

### (7) Heat-sealing strength

For the measurement of heat-sealing strength, a laminate (laminated deposited film) having a structure of aluminum oxide deposit layer/substrate film/polyurethane laminate layer//adhesive/LLDPE film was used.

### (Heat-sealing strength in dry state)

The surface of the LLDPE film of the laminated deposited film was allowed to face a surface of the LLDPE film of another laminated deposited film, and they were heat-sealed under the conditions of 130°C, 1 second and 2.0 kg/cm². Then, a test specimen of 15 mm width was cut off, and the heat-sealing strength of the specimen was measured at a rate of 300 mm/min.

### (Heat-sealing strength after boiling)

The surface of the LLDPE film of the laminated deposited film was allowed to face a surface of the LLDPE film of another laminated deposited film, and they were heat-sealed under the conditions of 130°C, 1 second and 2.0 kg/cm². Then, a test specimen of 15 mm width was cut off, and the specimen was boiled for 1 hour in boiling water. Then, the heat-sealing strength of the specimen in a wet state was measured at a rate of 300 mm/min.

### Example 1

On one surface of a biaxially oriented polyethylene terephthalate film (PET film) having a thickness of 12 µm as a substrate, aluminum was thermally vaporized by an electron beam heating method with feeding oxygen at a feed rate of 3.7 liters/min based on 1 m of a width of the substrate film. Thus, an aluminum oxide deposited film having a light transmittance of 77 % was prepared at a deposition rate of 600 m/min. Then, on the deposit layer side surface of the film given immediately after deposition was dry laminated a film of LLDPE (density: 0.920 g/cm³, MFR: 3.8 g/10min) having a thickness of 50 µm to prepare a double layer film. The properties of the double layer film are set forth in Table 1.

### Example 2

On one surface of a biaxially oriented PET film having a thickness of 12 µm as a substrate, aluminum was thermally vaporized by an electron beam heating method with feeding oxygen at a feed rate of 3.4 liters/min based on 1 m of a width of the substrate film. Thus, an aluminum oxide deposited film having a light transmittance of 80 % was prepared at a deposition rate of 600 m/min. Then, a double layer film was prepared in the same manner as in Example 1. The properties of the double layer film are set forth in Table 1.

### Comparative Example 1

On one surface of a biaxially oriented PET film having a thickness of 12 µm as a substrate, aluminum was thermally vaporized by an electron beam heating method without feeding oxygen. Thus, an aluminum oxide deposited film having a light transmittance of 61 % was prepared at a deposition rate of 600 m/min. Then, a double layer film was prepared in the same manner as in Example 1. The properties of the double layer film are set forth in Table 1.

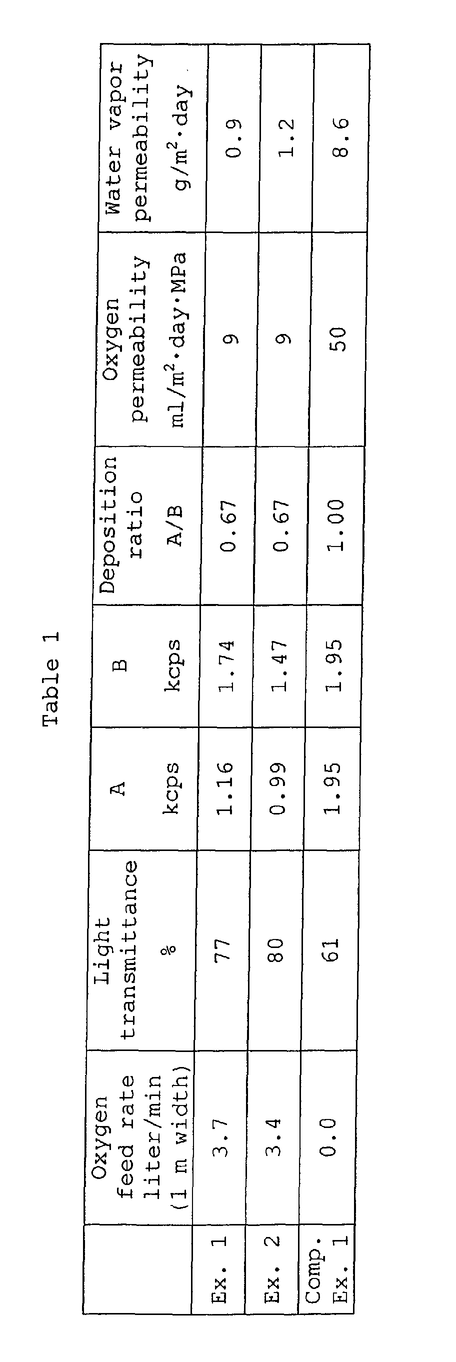

### Example 3

On one surface of a biaxially oriented PET film having a thickness of 12 µm as a substrate, aluminum was thermally vaporized by an electron beam heating method with feeding oxygen at a feed rate of 4.6 liters/min based on 1 m of a width of the substrate film. Thus, an aluminum oxide deposited film having a light transmittance of 85 % was prepared at a deposition rate of 600 m/min.

Then, the deposited film wound around a reel was unwound in the atmosphere and rewound around another reel. The deposited film was allowed to stand for 2 days. Then, a double layer film was prepared in the same manner as in Example 1. The properties of the double layer film are set forth in Table 2.

### Example 4

On one surface of a biaxially oriented PET film having a thickness of 12 µm as a substrate, aluminum was thermally vaporized by an electron beam heating method with feeding oxygen at a feed rate of 4.6 liters/min based on 1 m of a width of the substrate film. Thus, an aluminum oxide deposited film having a light transmittance of 85 % was prepared at a deposition rate of 600 m/min. The aluminum oxide deposited film was then successively introduced into three plasma discharge chambers equipped in the deposition apparatus. To the plasma discharge chambers, oxygen was fed at a feed rate of 0.25 liter/min based on 1 m of a width of the aluminum oxide deposited film to carry out plasma discharge. Using resulting deposited film, a double layer film was prepared in the same manner as in Example 1. The properties of the double layer film are set forth in Table 2.

### Reference Example 1

On one surface of a biaxially oriented PET film having a thickness of 12 µm as a substrate, aluminum was thermally vaporized by an electron beam heating method with feeding oxygen at a feed rate of 4.6 liters/min based on 1 m of a width of the substrate film. Thus, an aluminum oxide deposited film having a light transmittance of 85 % was prepared at a deposition rate of 600 m/min. Using the deposited film obtained immediately after the deposition, a double layer film was prepared in the same manner as in Example 3. The properties of the double layer film were measured and are set forth in Table 2.

### Comparative Example 2

On one surface of a biaxially oriented PET film having a thickness of 12 µm as a substrate, aluminum was thermally vaporized by an electron beam heating method with feeding oxygen at a feed rate of 6.0 liters/min based on 1 m of a width of the substrate film. Thus, an aluminum oxide deposited film having a light transmittance of 99 % was prepared at a deposition rate of 600 m/min.

Then, the deposited film wound around a reel was unwound in the atmosphere and rewound around another reel. The deposited film was allowed to stand for 2 days and a double layer film was prepared in the same manner as in Example 1. The properties of the double layer film were measured and are set forth in Table 2.

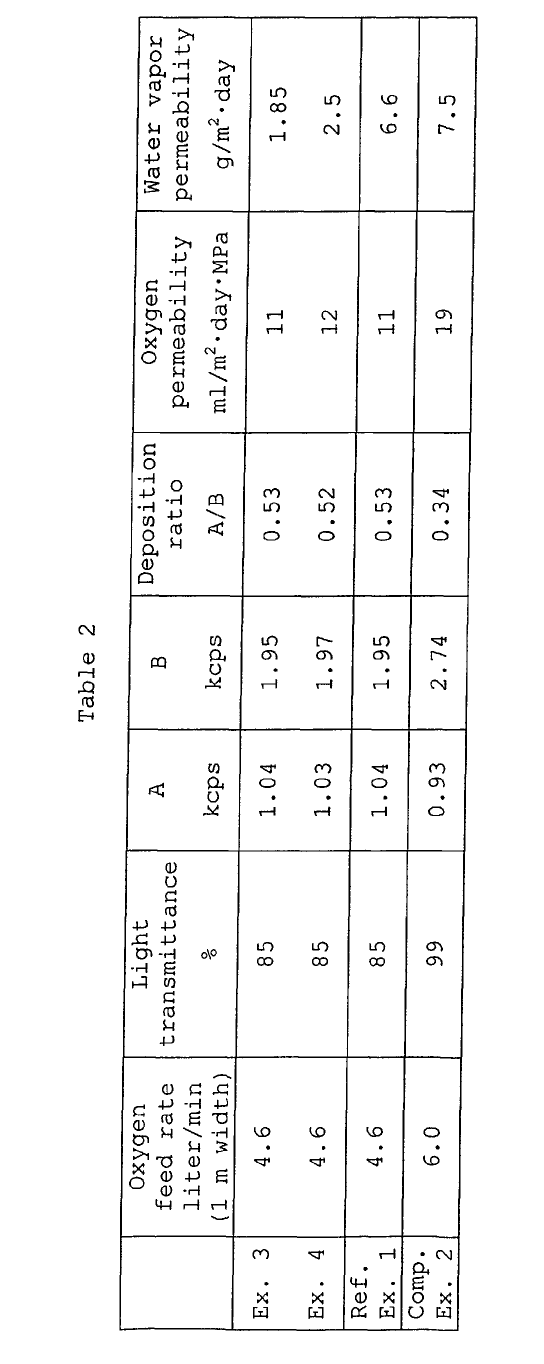

It can be seen from comparison between Example 3 and Reference Example 1 that the water vapor barrier properties were improved by allowing the aluminum oxide deposit layer into contact with oxygen to oxidize the aluminum oxide after the deposition of the aluminum oxide. It can be also seen that when the deposition ratio (A/B) was less than 0.35 as in Comparative Example 2, the water vapor barrier properties were not improved even by conducting rewinding.

### Example 5

To a biaxially oriented polyester film (PET film) having a thickness of 12 µm, oxygen was fed in the rotation direction of a chill roll at a feed rate of 3.2 liters/min based on 1 m of a width of the substrate film from the oxygen feed nozzle arranged on the substrate film unwind side and on the substrate film side of the masking board and positioned at a distance of 20 mm from the substrate film, while the deposition quantity of aluminum was controlled so that the light transmittance became 79%. Thus, an aluminum oxide deposited film was prepared. The deposition ratio (A/B) of the aluminum oxide deposited film was 0.70.

After bringing the deposit layer of the aluminum oxide deposited film into contact with oxygen in atmosphere thoroughly, on the deposit layer side surface of the deposited film was laminated a film of LLDPE (density: 0.920 g/cm³, MFR: 3.8 g/10min) having a thickness of 50 µm to prepare a double layer film. The residual percentage of aluminum on the surface of the substrate film given after measuring a laminate strength (peel strength) in a wet state was 10 %. With respect to the aluminum oxide deposited film, the measured properties are set forth in Table 3.

### Example 6

To a PET film, oxygen was fed in the rotation direction of a chill roll at a feed rate of 4 liters/min based on 1 m of a width of the substrate film from the oxygen feed nozzle arranged on the substrate film unwind side and on the substrate film side of the masking board, while the deposition quantity of aluminum was controlled so that the light transmittance became 85 %. Thus, an aluminum oxide deposited film was prepared. The deposition ratio (A/B) of the aluminum oxide deposited film was 0.60.

After bringing the deposit layer of the aluminum oxide deposited film into contact with oxygen in atmosphere thoroughly, a double layer film was prepared in the same as in Example 5. The residual percentage of aluminum on the surface of the substrate film given after measuring a laminate strength (peel strength) in a wet state was 18 %.

With respect to the aluminum oxide deposited film, the measured properties are set forth in Table 3.

### Example 7

To a PET film, oxygen was fed in the rotation direction of a chill roll at a feed rate of 4.5 liters/min based on 1 m of a width of the substrate film from the oxygen feed nozzle arranged on the substrate film unwind side and on the substrate film side of the masking board, while the deposition quantity of aluminum was controlled so that the light transmittance became 90%. Thus, an aluminum oxide deposited film was prepared. The deposition ratio (A/B) of the aluminum oxide deposited film was 0.50.

After bringing the deposit layer of the aluminum oxide deposited film into contact with oxygen in atmosphere thoroughly, a double layer film was prepared in the same as in Example 5. The residual percentage of aluminum on the surface of the substrate film given after measuring a laminate strength (peel strength) in a wet state was 22 %.

With respect to the aluminum oxide deposited film, the measured properties are set forth in Table 3.

### Reference Example 2

To a PET film, oxygen was fed in the rotation direction of a chill roll at a feed rate of 6 liters/min based on 1 m of a width of the substrate film from the oxygen feed nozzle arranged on the substrate film unwind side and on the substrate film side of the masking board, while the deposition quantity of aluminum was controlled so that the light transmittance became 99 %. Thus, an aluminum oxide deposited film was prepared. The deposition ratio (A/B) of the aluminum oxide deposited film was 0.20.

After bringing the deposit layer of the aluminum oxide deposited film into contact with oxygen in atmosphere thoroughly, a double layer film was prepared in the same as in Example 5. The residual percentage of aluminum on the surface of the substrate film given after measuring a laminate strength (peel strength) in a wet state was 15 %.

With respect to the aluminum oxide deposited film, the measured properties are set forth in Table 3.

### Comparative Example 3

To a PET film, oxygen was fed in the rotation direction of a chill roll at a feed rate of 1 liter/min based on 1 m of a width of the substrate film from the oxygen feed nozzle arranged on the substrate film unwind side and on the substrate film side of the masking board, while the deposition quantity of aluminum was controlled so that the light transmittance became 60%. Thus, an aluminum oxide deposited film was prepared. The deposition ratio (A/B) of the aluminum oxide deposited film was 0.95.

After bringing the deposit layer of the aluminum oxide deposited film into contact with oxygen in atmosphere thoroughly, a double layer film was prepared in the same as in Example 5. The residual percentage of aluminum on the surface of the substrate film given after measuring a laminate strength (peel strength) in a wet state was 0 %.

With respect to the aluminum oxide deposited film, the measured properties are set forth in Table 3.

### Reference Example 3

To a PET film, oxygen was fed in the rotation direction of a chill roll at a feed rate of 4 liters/min based on 1 m of a width of the substrate film from the oxygen feed nozzle arranged on the substrate film unwind side and on the external side of the masking board and positioned at a distance of 200 mm from the substrate film, while the deposition quantity of aluminum was controlled so that the light transmittance became 85%. Thus, an aluminum oxide deposited film was prepared. The deposition ratio (A/B) of the aluminum oxide deposited film was 0.60.

After bringing the deposit layer of the aluminum oxide deposited film into contact with oxygen in atmosphere thoroughly, a double layer film was prepared in the same as in Example 5. The residual percentage of aluminum on the surface of the substrate film given after measuring a laminate strength (peel strength) in a wet state was 3 %.

With respect to the aluminum oxide deposited film, the measured properties are set forth in Table 3.

### Reference Example 4

The peel strength of a commercially available aluminum oxide deposited biaxially oriented polyester film (available from Toyo Metallizing Co., Ltd., BARRIALOX 1011HG) in a wet state was 0.1 N/15mm. The residual percentage of aluminum on the substrate film surface was 0 %.

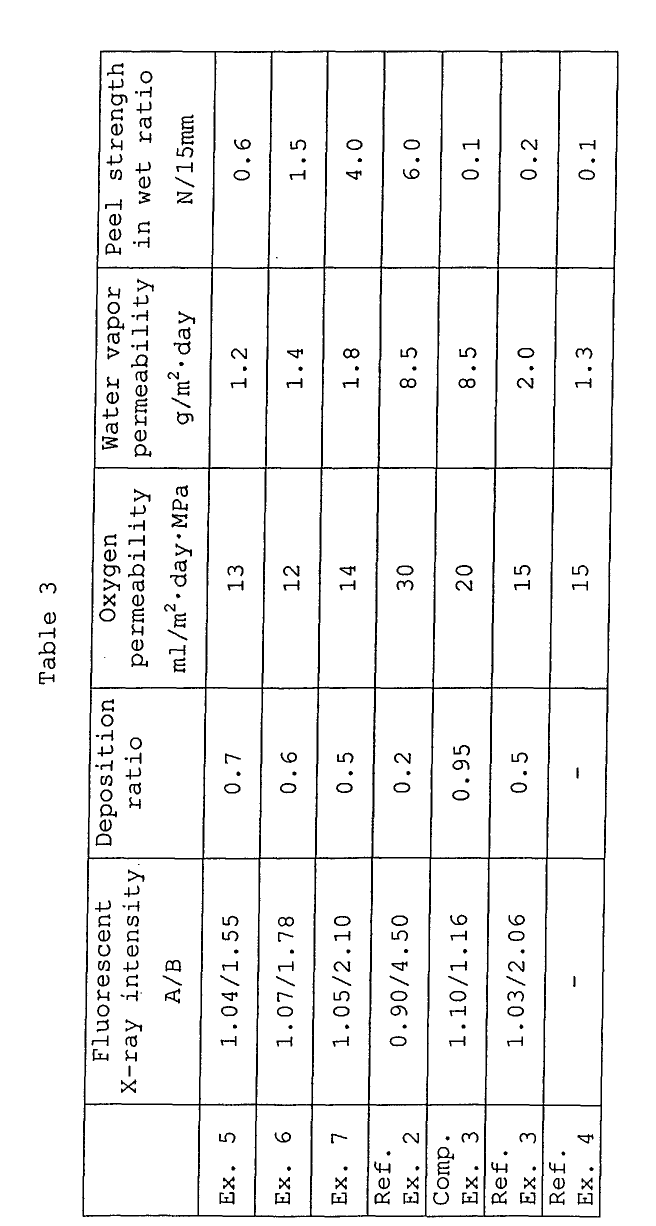

As is apparent from Table 3, the aluminum oxide deposited films (Examples 5 to 7) obtained when the deposition ratio was 0.7 to 0.5 had an oxygen permeability of not more than 14.0 ml/m²·day·MPa and a water vapor permeability of not more than 2.0 g/m²·day, so that the resistance to oxygen permeation and the resistance to water vapor permeation were very excellent. In those films, further, the peel strength of the deposit layer to the substrate film in a wet state was not less than 0.6 N/15mm, so that the bond strength in a wet state was also excellent. On the other hand, in the aluminum oxide deposited film (Reference Example 2) obtained when the deposition ratio was 0.2, the resistance to oxygen permeation and the resistance to water vapor permeation were slightly lowered though the peel strength of the deposit layer to the substrate film in a wet state was 6.5 N/15mm and high.

In the aluminum oxide deposited film (Comparative Example 3) obtained when the deposition ratio was 0.95, the peel strength of the deposit layer to the substrate film in a wet state was 0.01 N/15mm and low. Moreover, the resistance to oxygen permeation and the resistance to water vapor permeation were not so good.

### Example 8

To a non-laminate surface of a biaxially oriented polyethylene terephthalate film (substrate film) having a thickness of 12 µm whose laminate surface had been precoated with a polyurethane resin and whose non-laminate surface had been subjected to corona treatment, oxygen was fed in the rotation direction of a chill roll at a feed rate of 4 liters/min based on 1 m of a width of the substrate film from the oxygen feed nozzle arranged on the biaxially oriented substrate film unwind side and between the masking board and the substrate film and positioned at a distance of 20 mm from the biaxially oriented substrate film, while the deposition quantity of aluminum was controlled so that the light transmittance became 85 %. Thus, an aluminum oxide deposited film was prepared. The deposition ratio (A/B) of the aluminum oxide deposited film was 0.6.

After bringing the aluminum oxide deposit layer of the aluminum oxide deposited film into contact with oxygen in atmosphere thoroughly, on a surface of the aluminum oxide deposit layer of the aluminum oxide deposited film, a biaxially oriented polypropylene film (OPP film, available from Tohcello, Co., trade name: ME-1) having a thickness of 20 µm was laminated by the use of a polyurethane dry laminating adhesive (available from Mitsui Takeda Chemical Ltd., mixing at a ratio of Takelac A310 (trade name):Takenate A3 (trade name) = 12:1, coating weight: 3 g/m²). Further, on the laminate surface of the aluminum oxide deposited film was laminated a heat-sealing layer made of a LLDPE film (available from Tohcello, Co., trade name: TUX FCS, density: 0.920 g/cm³, MFR: 3.8 g/10min) having a thickness of 50 µm by the use of a polyurethane dry laminating adhesive (available from Mitsui Takeda Chemical Ltd., mixing at a ratio of Takelac A310 (trade name):Takenate A3 (trade name) = 12:2, coating weight: 3 g/m²). Thus, a laminated deposited film was obtained.

With respect to the laminated deposited film, the oxygen permeability, water vapor permeability, peel strength of the non-laminate surface (in a dry state and in a wet state), residual percentage on the non-laminate surface, peel strength of the laminate surface (in a dry state and in a wet state), and heat-sealing strength (a laminate having a structure of aluminum oxide deposit layer/substrate film/polyurethane laminate layer//adhesive/LLDPE film, in a dry state and after boiling) were measured. The results are set forth in Table 4 and Table 5.

### Reference Example 5

To the same type of a biaxially oriented polyethylene terephthalate film (substrate film) as used in Example 8, oxygen was fed in the rotation direction of a chill roll at a feed rate of 5.3 liters/min based on 1 m of a width of the substrate film from the oxygen feed nozzle arranged on the substrate film unwind side and between the masking board and the substrate film, while the deposition quantity of aluminum was controlled so that the light transmittance became 97 %. Thus, an aluminum oxide deposited film was prepared. The deposition ratio (A/B) of the aluminum oxide deposited film was 0.3.

Using the aluminum oxide deposited film, a laminated deposited film was prepared in the same manner as in Example 8. The properties of the laminated deposited film are set forth in Table 4 and Table 5.

### Reference Example 6

To a non-laminate surface of a biaxially oriented polyethylene terephthalate film (substrate film) having a thickness of 12 µm whose non-laminate surface had been subjected to corona treatment and whose laminate surface had not been precoated with a polyurethane resin, oxygen was fed in the rotation direction of a chill roll at a feed rate of 4 liters/min based on 1 m of a width of the substrate film from the oxygen feed nozzle arranged on the biaxially oriented substrate film unwind side and between the masking board and the substrate film and positioned at a distance of 20 mm from the biaxially oriented substrate film, while the deposition quantity of aluminum was controlled so that the light transmittance became 85%. Thus, an aluminum oxide deposited film was prepared. The deposition ratio (A/B) of the aluminum oxide deposited film was 0.6.

Using the aluminum oxide deposited film, a laminated deposited film was prepared in the same manner as in Example 8. The properties of the laminated deposited film are set forth in Table 4 and Table 5.

### Comparative Example 4

To a non-laminate surface of the same type of a biaxially oriented polyethylene terephthalate film (substrate film) having a thickness 12 µm as used in Reference Example 6 whose non-laminate surface had been subjected to corona treatment and whose laminate surface had not been precoated with a polyurethane resin, oxygen was fed in the rotation direction of a chill roll at a feed rate of 1 liter/min based on 1 m of a width of the substrate film from the oxygen feed nozzle arranged on the biaxially oriented substrate film unwind side and between the masking board and the substrate film, while the deposition quantity of aluminum was controlled so that the light transmittance became 60 %. Thus, an aluminum oxide deposited film was prepared. The deposition ratio (A/B) of the aluminum oxide deposited film was 0.95.

Using the aluminum oxide deposited film, a laminated deposited film was prepared in the same manner as in Example 8. The properties of the laminated deposited film are set forth in Table 4 and Table 5.

### Reference Example 7

The same type of a biaxially oriented polyethylene terephthalate film having a thickness 12 µm as used in Reference Example 6 whose non-laminate surface had been subjected to corona treatment and whose laminate surface had not been precoated with a polyurethane resin was used as a substrate film.

On the non-laminate surface of the biaxially oriented polyethylene terephthalate film was laminated a LLDPE film (available from Tohcello, Co., trade name: TUX FCS, density: 0.920 g/cm³, MFR: 3.8 g/10min) having a thickness of 50 µm by the use of a polyurethane dry laminating adhesive (available from Mitsui Takeda Chemical Ltd., mixing at a ratio of Takelac A310 (trade name):Takenate A3 (trade name) = 12:2, coating weight: 3 g/m²) to prepare a double layer film.

With respect to the double layer film, the peel strength between the biaxially oriented polyethylene terephthalate and the LLDPE film and the heat-sealing strength were measured in the same manner as in Example 8.

The results are set forth in Table 4 and Table 5.

### Reference Example 8

To the laminate surface precoated with polyurethane of the same type of a biaxially oriented polyethylene terephthalate film (substrate film) as used in Example 8, oxygen was fed in the rotation direction of a chill roll at a feed rate of 4 liters/min based on 1 m of a width of the substrate film from the oxygen feed nozzle arranged on the biaxially oriented substrate film unwind side and between the masking board and the substrate film and positioned at a distance of 20 mm from the biaxially oriented substrate film, while the deposition quantity of aluminum was controlled so that the light transmittance became 85%. Thus, an aluminum oxide deposited film was prepared. The deposition ratio (A/B) of the aluminum oxide deposited film was 0.5.

On the deposit layer surface of the aluminum oxide deposited film, a heat-sealing layer made of a LLDPE film (available from Tohcello, Co., trade name: TUX FCS, density: 0.920 g/cm³, MFR: 3.8 g/10min) having a thickness of 50 µm by the use of a polyurethane dry laminating adhesive (available from Mitsui Takeda Chemical Ltd., mixing at a ratio of Takelac A310 (trade name) :Takenate A3 (trade name) = 12:1, coating weight: 3 g/m²) was laminated in the same manner as in Example 11. With respect to the resulting laminated film, the oxygen permeability and the water vapor permeability was measured in the same manner as in Example 8.

The results are set forth in Table 4 and Table 5.

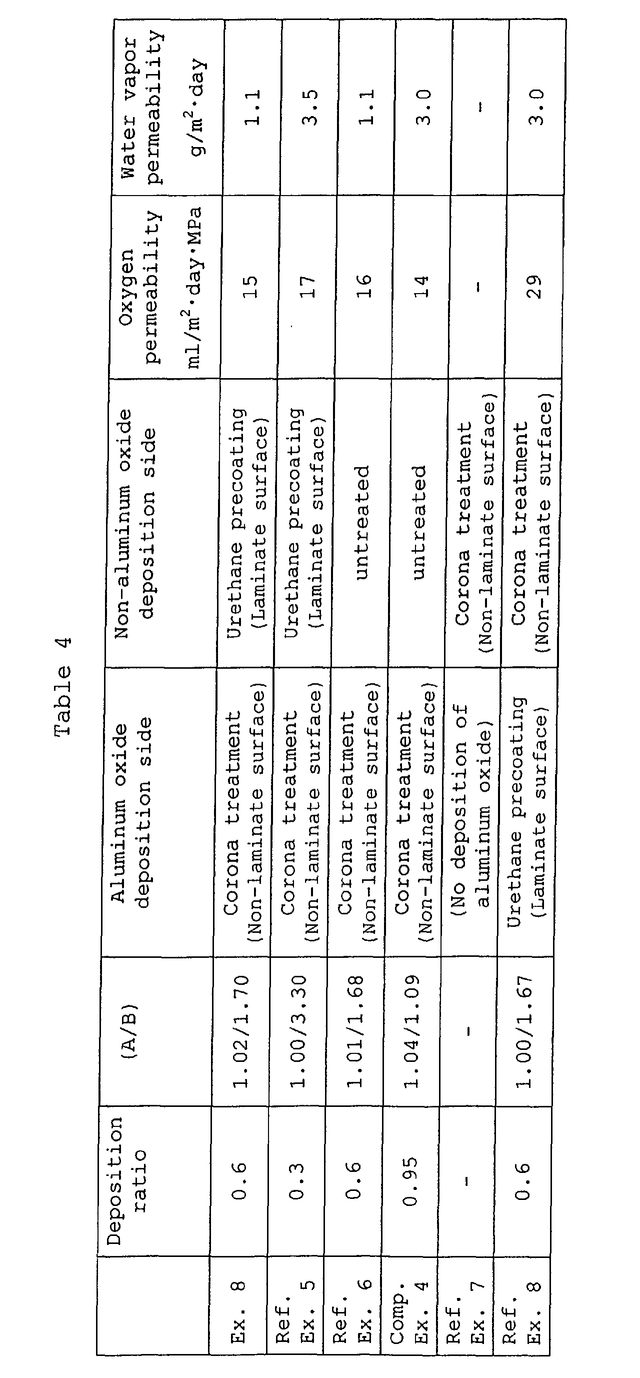

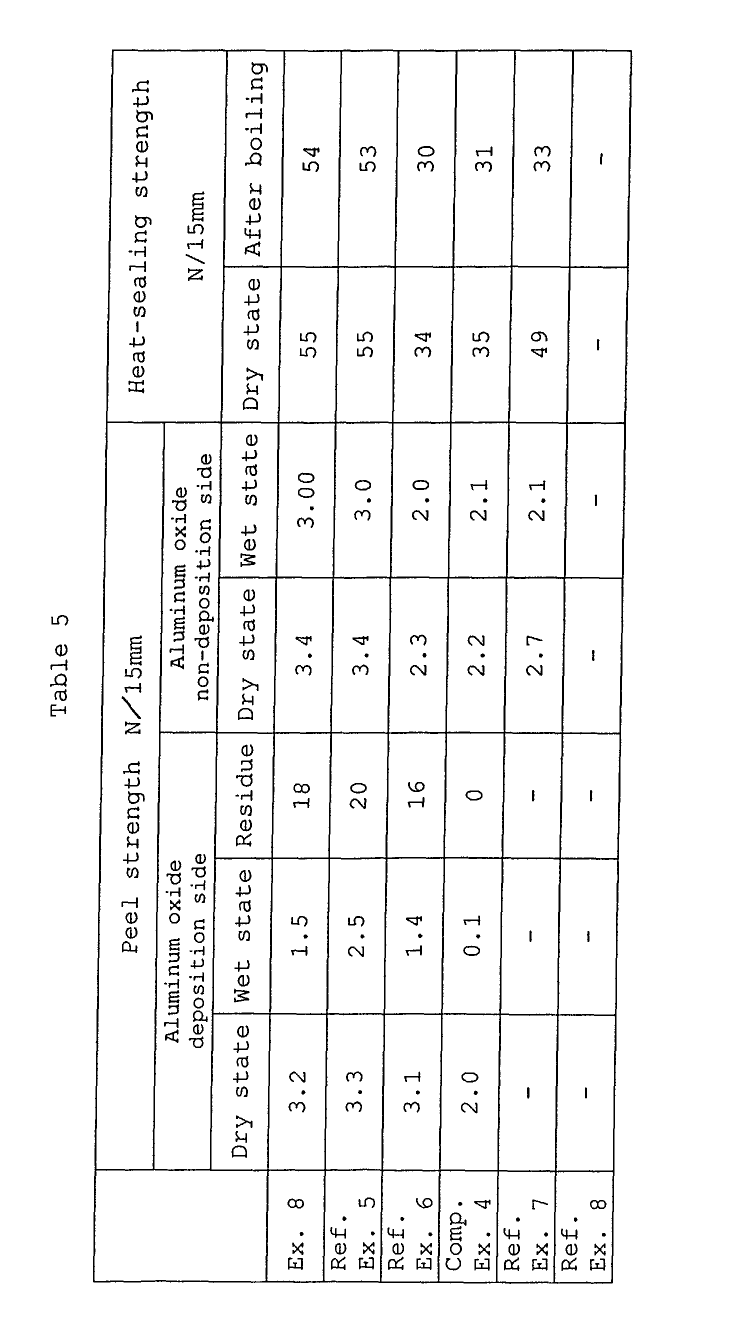

As is apparent from Table 4 and Table 5, the aluminum oxide deposited film (Example 8) obtained when the deposition ratio was 0.6 had an oxygen permeability of 15 ml/m²·day·MPa and a water vapor permeability of 1.1 g/m²·day, so that the resistance to oxygen permeation and the resistance to water vapor permeation were both very excellent. In this film, further, the peel strength between the non-laminate surface of the biaxially oriented substrate film and the aluminum oxide deposit layer in a wet state was 1.5 N/15mm, so that the bond strength in a wet state was also excellent. Moreover, the peel strength between the laminate surface of the biaxially oriented substrate film and the heat-sealing layer (heat-sealing film) in a dry state and in a wet state, and the heat-sealing strength in a dray state and after boiling were also excellent.

The aluminum oxide deposited film (Reference Example 5) obtained when the deposition ratio was 0.3 tended to be inferior to the aluminum oxide deposited film obtained in Example 8 in the resistance to oxygen permeation and the resistance to water vapor permeation. However, the peel strength between the non-laminate surface of the biaxially oriented substrate film and the aluminum oxide deposit layer in a wet state was 2.5 N/15mm, so that the bond strength in a wet ratio was better. With respect to the peel strength between the laminate surface of the biaxially oriented substrate film and the heat-sealing layer (heat-sealing film) and the heat-sealing strength, this aluminum oxide deposited film is equivalent to the aluminum oxide deposited film obtained in Example 8.

On the other hand, the aluminum oxide deposited film (Reference Example 6) obtained by the use of a biaxially oriented polyethylene terephthalate film whose laminate surface had not been precoated with a polyurethane resin exhibited poor peel strength between the laminate surface of the biaxially oriented substrate film and the heat-sealing layer and poor heat-sealing strength, though it had excellent resistance to oxygen permeation, excellent resistance to water vapor permeation and excellent peel strength between the aluminum oxide deposit layer and the non-laminate surface of the biaxially oriented substrate film.

In the aluminum oxide deposited film (Comparative Example 4) obtained when the deposition ratio was 0.95, the peel strength of the non-laminate surface of the substrate film in a wet state was 0.1 N/15mm and insufficient. In addition, the resistance to water vapor permeation was not so good.

The deposited film of Reference Example 8 obtained by depositing aluminum oxide on the laminate surface of the biaxially oriented polyethylene terephthalate film having been precoated with polyurethane (i.e., embodiment having a deposit layer on the surface opposite to that of Example 8, aluminum oxide deposition ratio: 0.6 was inferior to the deposited films obtained in Example 8 in the resistance to oxygen permeation and the resistance to water vapor permeation.

## Claims

1. An aluminum oxide deposited film comprising a substrate film and an aluminum oxide deposit layer of which the peel strength to the substrate film in a wet state is at least 0.3 N/15mm.

2. The aluminum oxide deposited film as claimed in claim 1, having an oxygen permeability of not more than 40 ml/m²·day·MPa and a water vapor permeability of not more than 4.0 g/ m²·day.

3. The aluminum oxide deposited film as claimed in claim 1, wherein the ratio (A/B) of a fluorescent X-ray intensity (A) kcps (aluminum Kα-ray) of the aluminum oxide deposited film (1) to a fluorescent X-ray intensity (B) kcps (aluminum Kα-ray) of an aluminum deposited film (2) obtained without feeding oxygen is (A/B) ≤ 0.85.

4. The aluminum oxide deposited film as claimed in claim 2, wherein the ratio (A/B) of a fluorescent X-ray intensity (A) kcps (aluminum Kα-ray) of the aluminum oxide deposited film (1) to a fluorescent X-ray intensity (B) kcps (aluminum Kα-ray) of an aluminum deposited film (2) obtained without feeding oxygen is 0.35 ≤ (A/B) ≤ 0.85.

5. The aluminum oxide deposited film as claimed in claim 1 or 2, obtained by depositing aluminum oxide in such a manner that the ratio (A/B) of a fluorescent X-ray intensity (A) kcps (aluminum Kα-ray) of the aluminum oxide deposited film (1) to a fluorescent X-ray intensity (B) kcps (aluminum Kα-ray) of an aluminum deposited film (2) obtained without feeding oxygen is 0.35 ≤ (A/B) ≤ 0.65 and then oxidizing the aluminum oxide deposit layer.

6. The aluminum oxide deposited film as claimed in any one of claims 1 to 5, wherein the fluorescent X-ray intensity (A) kcps of the aluminum oxide deposited film (1) is 0.5 to 10 kcps.

7. The aluminum oxide deposited film as claimed in any one of claims 1 to 5, wherein the substrate film is a biaxially oriented substrate film.

8. The aluminum oxide deposited film as claimed in claim 7, wherein a laminate surface of the biaxially oriented substrate film is precoated with a polyurethane resin layer and aluminum oxide is deposited on a non-laminate surface of the biaxially oriented substrate film.

9. The aluminum oxide deposited film as claimed in claim 7 or 8, wherein the biaxially oriented substrate film is a biaxially oriented polyester substrate film.

10. The aluminum oxide deposited film as claimed in any one of claims 1 to 5, wherein a heat-sealing layer is laminated on the surface film or the surface of the aluminum oxide deposit layer of the aluminum oxide deposited film.

11. The aluminum oxide deposited film as claimed in claim 8, wherein a heat-sealing layer is laminated on the laminate surface of the biaxially oriented substrate film.

12. A process for producing an aluminum oxide deposited film, comprising allowing oxygen to react with aluminum vapor in vacuo to deposit aluminum oxide on a substrate film in such a manner that the ratio (A/B) of a fluorescent X-ray intensity (A) kcps (aluminum Kα-ray) of the resulting aluminum oxide deposited film (1) to a fluorescent X-ray intensity (B) kcps (aluminum Kα-ray) of an aluminum deposited film (2) obtained without feeding oxygen is 0.35 ≤ (A/B) ≤ 0.85.

13. The process for producing an aluminum oxide deposited film as claimed in claim 12, wherein the ratio of (A/B) is 0.45 ≤ (A/B) ≤ 0.85.

14. A process for producing an aluminum oxide deposited film, comprising allowing oxygen to react with aluminum vapor in vacuo to deposit aluminum oxide on a substrate film in such a manner that the ratio (A/B) of a fluorescent X-ray intensity (A) kcps (aluminum Kα-ray) of the resulting aluminum oxide deposited film (1) to a fluorescent X-ray intensity (B) kcps (aluminum Kα-ray) of an aluminum deposited film (2) obtained without feeding oxygen is 0.35 ≤ (A/B) ≤ 0.65 and then bringing the aluminum oxide deposit layer into contact with oxygen to oxidize the aluminum oxide deposit layer.

15. The process for producing an aluminum oxide deposited film as claimed in any one of claims 12 to 14, wherein the fluorescent X-ray intensity (A) kcps of the aluminum oxide deposited film (1) is in the range of 0.5 to 10 kcps.

16. The process for producing an aluminum oxide deposited film as claimed in any one of claims 12 to 14, wherein the reaction of oxygen with aluminum vapor is carried out by feeding oxygen from a feed nozzle in the rotation direction of a chill roll and against the aluminum vapor, said feed nozzle being arranged on the unwind side of the substrate film and in the width direction of a masking board.

17. The process for producing an aluminum oxide deposited film as claimed in claim 16, wherein the feed nozzle is in a position at a distance of 1 to 150 mm from the substrate film.

18. The process for producing an aluminum oxide deposited film as claimed in claim 14, wherein after completion of the deposition, the aluminum oxide deposit layer is brought into contact with oxygen by rewinding the aluminum oxide deposited film in the atmosphere.

19. The process for producing an aluminum oxide deposited film as claimed in claim 14, wherein after the deposition and before wind-up of the aluminum oxide deposited film, the aluminum oxide deposit layer is brought into contact with oxygen and oxygen plasma in a deposition apparatus.

20. The process for producing an aluminum oxide deposited film as claimed in claim 14, wherein the aluminum oxide deposit layer is brought into contact with oxygen and oxygen plasma in at least one plasma discharge chamber arranged in a deposition apparatus.

21. The process for producing an aluminum oxide deposited film as claimed in any one of claims 12 to 14, wherein the substrate film is a biaxially oriented substrate film.

22. The process for producing an aluminum oxide deposited film as claimed in claim 21, wherein aluminum oxide is deposited on a non-laminate surface of a biaxially oriented substrate film whose laminate surface has been precoated with a polyurethane resin layer.

23. The process for producing an aluminum oxide deposited film as claimed in claim 22, wherein a heat-sealing layer is laminated on the laminate surface of the aluminum oxide deposited film directly or through an adhesive layer.
